(19) Europäisches Patentamt
European Patent Office
Office européen des brevets

(11) **EP 2 917 707 B1**

(12) **FASCICULE DE BREVET EUROPEEN**

(45) Date de publication et mention
de la délivrance du brevet:
**07.09.2016 Bulletin 2016/36**

(21) Numéro de dépôt: **13786288.4**

(22) Date de dépôt: **06.11.2013**

(51) Int Cl.:
*G01J 1/44* (2006.01)    *G01J 1/46* (2006.01)
*G01J 1/42* (2006.01)    *H03F 3/08* (2006.01)

(86) Numéro de dépôt international:
**PCT/EP2013/073198**

(87) Numéro de publication internationale:
**WO 2014/072362 (15.05.2014 Gazette 2014/20)**

(54) **RECEPTEUR D'UN SIGNAL LUMINEUX IMPULSIONNEL A FORTE DYNAMIQUE**

EMPFÄNGER EINES GEPULSTEN LICHTSIGNALS MIT GROSSEM DYNAMIKBEREICH

RECEIVER OF A PULSED LIGHT SIGNAL WITH WIDE DYNAMIC RANGE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.11.2012 FR 1203012**

(43) Date de publication de la demande:
**16.09.2015 Bulletin 2015/38**

(73) Titulaire: **France Brevets
75009 Paris (FR)**

(72) Inventeurs:
• **VERYERAS, Alexandre
F-78640 Villiers-Saint-Frédéric (FR)**
• **PASSELAIGUE, Daniel
F-78580 Maule (FR)**

(74) Mandataire: **Henriot, Marie-Pierre
Marks & Clerk France
Conseils en Propriété Industrielle
Immeuble Visium
22, Avenue Aristide Briand
94117 Arcueil Cedex (FR)**

(56) Documents cités:
**US-A- 4 415 803        US-A1- 2004 036 012
US-A1- 2006 001 493      US-B1- 6 862 322**

**Description**

Le domaine de l'invention est celui d'un récepteur à photodiode qui reçoit des impulsions lumineuses dans une très grande dynamique (de quelques nanoampères à quelques dizaines de milliampères). Cette dynamique met en oeuvre un dispositif de commutation du gain par valeurs discrètes, appelées « plots ».

La solution la plus couramment mise en oeuvre pour obtenir un tel récepteur consiste à équiper une photodiode d'un amplificateur TIA acronyme de l'expression anglo-saxonne « TransImpedance Amplifier » ; cet amplificateur TIA de fort produit gain bande (ou GBW acronyme de l'expression anglo-saxonne « Gain Bandwidth Product ») et de très faible bruit conditionne la performance de sensibilité.

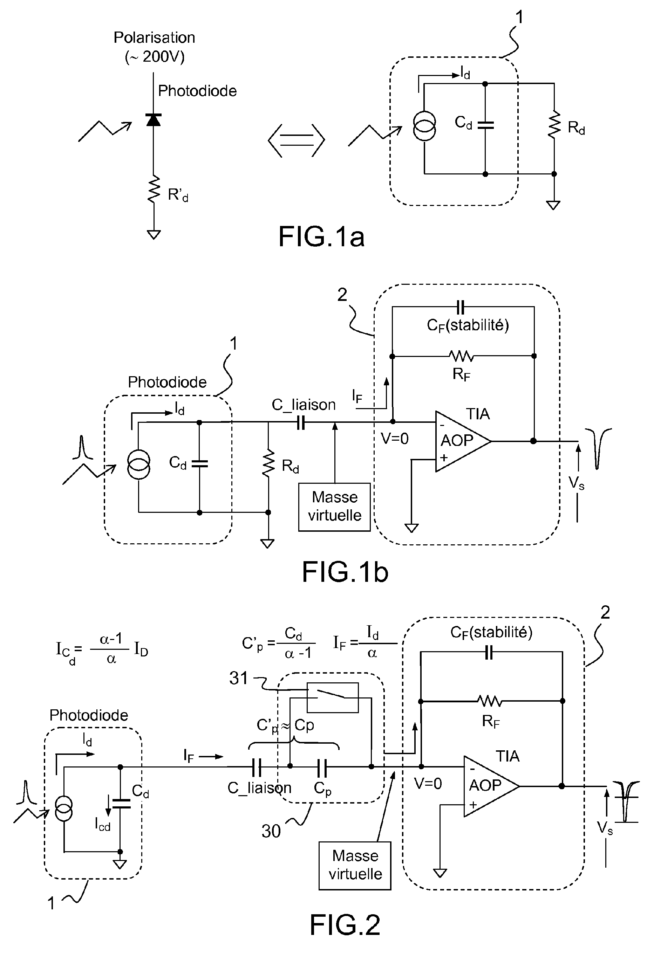

On représente de manière classique une photodiode 1 par le montage montré figure 1 a. Comme montré sur la figure de gauche, cette photodiode est de préférence chargée par une résistance R'$_d$ entre l'anode et la masse de manière à absorber le courant continu lié à l'éclairement ambiant aussi désigné courant de fond de scène, et qui est inclus dans le signal lumineux reçu par la photodiode. Selon la représentation équivalente montrée sur la figure de droite, cette résistance R'$_d$ en parallèle avec la résistance interne de la photodiode forme une résistance équivalente Rd. La photodiode est généralement caractérisée par une capacité Cd entre l'anode et la masse, montrée sur la figure de droite.

Dans un montage classique de récepteur dont un exemple est représenté figure 1b, une telle photodiode 1 est associée à un amplificateur TIA 2 à travers une capacité de liaison C$_{liaison}$ qui contribue à séparer les impulsions utiles du courant de fond de scène. La valeur de cette capacité de liaison C$_{liaison}$ est typiquement supérieure à 10 nF. On rappelle qu'un amplificateur TIA comprend en parallèle un amplificateur opérationnel AOP ou un amplificateur à composants discrets, une résistance de contre-réaction R$_f$ et une capacité de stabilité C$_f$. Un tel récepteur permet de neutraliser l'influence de la capacité parasite C$_d$ de la photodiode grâce à une masse virtuelle.

C'est en première approximation un système bouclé d'ordre 2 :

- De gain de conversion Z$_T$(p) tel que

$$Z_T(p) = \frac{V_s}{i_D} = -R_f \frac{1}{1 + \frac{2\zeta}{\omega_n}p + \frac{p^2}{\omega_n{}^2}} \quad (eq\ 1)$$

V$_s$ étant la tension en sortie du montage, i$_D$ le courant généré par la photodiode, p (p = j ω = j 2π f) la variable de Laplace, R$_f$ la résistance de contre-réaction du TIA, ζ l'amortissement du récepteur.

- et de pulsation propre $\omega_n$ telle que :

$$\omega_n = \sqrt{\frac{2\pi\ GBW}{R_f(C_d + C_f)}} \quad (eq\ 2)$$

Le rapport amortissement sur pulsation propre s'écrit :

$$\frac{\zeta}{\omega_n} = \frac{1}{2}\left(R_f C_f + \frac{1}{2\pi GBW}\left(1 + \frac{R_f}{R_d}\right)\right) \quad (eq\ 3)$$

en pratique :

$$R_f C_f \gg \frac{1}{2\pi GBW}\left(1 + \frac{R_f}{R_d}\right) \quad (eq\ 4)$$

ce rapport prend alors la forme simple :

$$\frac{\zeta}{\omega_n} \approx \frac{1}{2} R_f C_f \quad (eq\ 5)$$

La modification du gain s'obtient d'après (eq 1) par le changement de la valeur $R_f$ qui suivant (eq 2) modifie la pulsation propre $\omega_n$ et donc l'amortissement $\zeta$ d'après (eq 5). Il apparaît donc difficile avec une solution conventionnelle de changer le gain sans modifier la fonction de transfert.

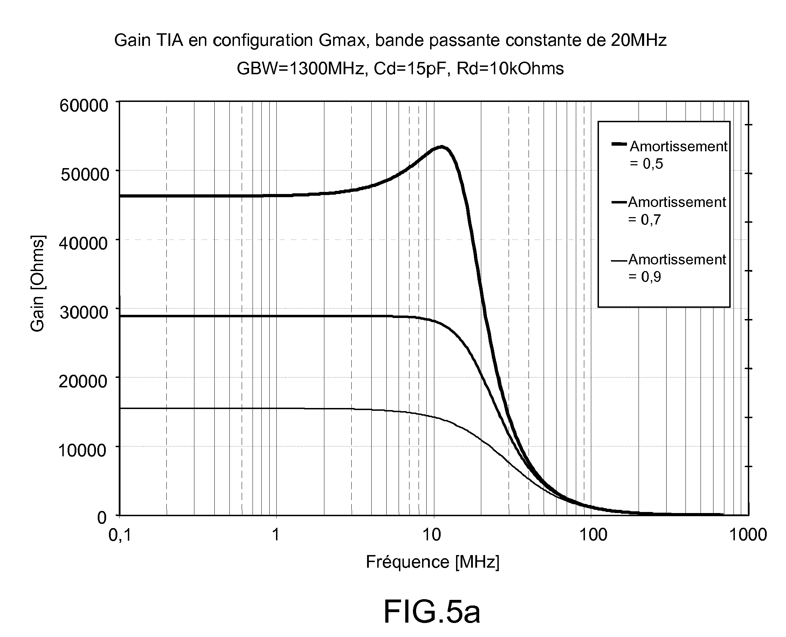

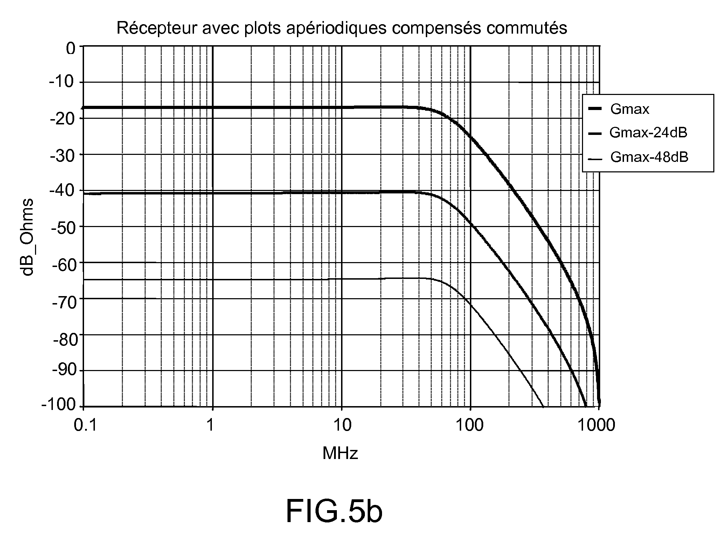

La réponse en fréquence est illustrée figure 5a pour trois amortissements $\zeta$ (de 0.9, 0.7 et 0.5). Cette figure met en évidence le fait que le changement du gain influence l'amortissement lorsque la bande est maintenue constante.

Un autre critère important est le bruit en courant équivalent, ramené à l'entrée de l'amplificateur TIA, qui s'écrit :

$$i_n = \sqrt{i_{n-}^2 + \left(\frac{e_n}{R_f}\right)^2 + \frac{4kT}{R_f}} \quad (eq\ 6)$$

$i_{n-}$ et $e_n$ étant respectivement le courant équivalent de bruit à l'entrée négative de l'amplificateur opérationnel AOP et la tension équivalente de bruit à l'entrée de AOP qui caractérisent l'amplificateur opérationnel utilisé, k la constante de Boltzmann et T la température en degrés Kelvin.

Pour un amplificateur TIA et une photodiode donnés, la sensibilité est optimisée en choisissant la résistance $R_f$ la plus élevée possible, compatible de la bande de traitement des impulsions.

Cependant, plus le gain est grand, plus l'admissibilité est faible puisque l'excursion en tension à la sortie de l'amplificateur est fixée par les alimentations. A contrario une diminution du gain augmente l'admissibilité mais détériore le bruit avec une limitation du courant imposée par le courant de sortie maximum de l'amplificateur.

Le problème se pose donc d'obtenir un récepteur optimum pour des signaux faibles mais aussi pour des signaux forts tout en conservant de préférence la même réponse en fréquence. Les solutions conventionnelles sont :

- Réduire le gain de l'amplificateur TIA, en diminuant la résistance de contre réaction $R_f$ qui fixe le gain de conversion du TIA, ce qui améliore l'admissibilité mais au détriment du bruit. D'autre part réduire la résistance de contre réaction a pour effet d'augmenter significativement la bande passante, ce qui n'est a priori pas souhaitable si on veut une forme d'impulsion indépendante du gain.
- Placer un atténuateur résistif commuté entre la photodiode et l'amplificateur TIA de manière à réduire le gain lorsque le niveau reçu dépasse l'admissibilité. Cela dégrade le bruit car les résistances génèrent du bruit. De plus les commutateurs présentent des capacités parasites non négligeables devant la capacité de la photodiode, ce qui affecte la fonction de transfert.

Les solutions conventionnelles ne répondent pas au besoin.

En conséquence, il demeure à ce jour un besoin pour un récepteur à grande dynamique optimisé en bruit.

Plus précisément l'invention a pour objet un récepteur d'un signal lumineux impulsionnel qui comprend :

- une photodiode apte à générer un courant électrique $I_d$ en réponse à ce signal lumineux, ayant comme caractéristique une capacité parasite $C_d$,
- une masse électrique,
- un amplificateur transimpédance relié en entrée de la photodiode par une capacité de liaison Liaison.

Il est principalement caractérisé en ce qu'il comporte un circuit réactif série-parallèle, constitué d'une capacité $C_p$ qui, combinée avec la capacité $C_d$ de la diode réalise un diviseur de courant, appelé plot d'atténuation, en amont de l'amplificateur transimpédance.

Ce diviseur de courant permet d'atténuer le signal sans dégrader le bruit.

La capacité Cp est typiquement située en série avec la capacité de liaison et l'intègre en général.

Selon une caractéristique de l'invention, le récepteur comporte une résistance $R_d$ de courant de fond de scène située entre la photodiode et la masse électrique, la capacité $C_d$ et ladite résistance $R_d$ ayant une impédance $Z_d$, et le plot d'atténuation est en outre constitué d'une résistance $R_p$ en parallèle avec la capacité $C_p$, formant ainsi un réseau électrique parallèle désigné plot d'atténuation apériodique, d'impédance $Z_p$ avec

$$Z_p = (\alpha - 1)Z_d.$$

Ce plot d'atténuation apériodique permet de compenser l'influence de la résistance Rd et ainsi de maintenir la réponse du récepteur en basse fréquence.

Eventuellement, le plot d'atténuation comporte en outre un commutateur en parallèle de la capacité $C_p$, de manière à obtenir un plot d'atténuation commutable. Ce commutateur permet de court-circuiter ou commuter le réseau $R_p \, C_p$.

Le plot d'atténuation peut comporter en outre une capacité $C_{opt}$ en parallèle de $C_d$, cette capacité $C_{opt}$ étant éventuellement elle-même commutable.

Le plot d'atténuation apériodique peut aussi être en outre constitué d'une capacité de compensation $C_{comp}$ en parallèle de l'entrée de l'amplificateur transimpédance, pour former ainsi un plot d'atténuation apériodique compensé, avec $C_{comp} = C_d \, (\alpha - 1)/\alpha$, cette capacité de compensation étant éventuellement commutable.

L'ensemble plot d'atténuation et amplificateur transimpédance étant désigné voie de réception à plot d'atténuation, le récepteur comporte en outre une voie de réception sans plot d'atténuation comportant un autre amplificateur transimpédance, ces voies de réception étant multiplexées au moyen d'un commutateur d'entrée de ces voies et d'un commutateur de sortie de ces voies synchronisés entre eux de manière à obtenir un récepteur de différents gains. Bien sûr plusieurs autres voies de réception à plot d'atténuation peuvent être multiplexées avec lesdites voies de réception, chaque voie de réception à plot d'atténuation présentant une atténuation différente.

Le signal lumineux est typiquement apte à générer dans la photodiode des impulsions de courant compris entre 10 nA et 100 mA.

D'autres caractéristiques et avantages de l'invention apparaîtront à la lecture de la description détaillée qui suit, faite à titre d'exemple non limitatif et en référence aux dessins annexés dans lesquels :

La figure 1 a déjà décrite montre deux représentations schématiques équivalentes d'une photodiode munie d'une résistance de fond de scène ;

La figure 1b représente schématiquement un montage de récepteur selon l'état de la technique comportant une photodiode et un amplificateur TIA ;

La figure 2 représente schématiquement un exemple de montage de récepteur selon un premier mode de réalisation de l'invention avec un plot d'atténuation purement capacitif ;

La figure 3a représente schématiquement un exemple de montage de récepteur selon un deuxième mode de réalisation de l'invention, avec un plot d'atténuation apériodique commuté autour de Rp Cp ;

La figure 3b représente schématiquement un exemple de montage de récepteur selon un troisième mode de réalisation de l'invention, avec un plot d'atténuation apériodique commuté autour de Cd ;

La figure 3c représente schématiquement un exemple de montage de récepteur selon un quatrième mode de réalisation de l'invention, avec un plot d'atténuation apériodique compensé ;

La figure 4 représente schématiquement un exemple de montage de récepteur selon un cinquième mode de réalisation de l'invention, avec plusieurs voies de réception commutées ;

La figure 5a montre la réponse en fréquence d'un récepteur classique à bande passante constante pour trois valeurs de gain, montrant une variation de l'amortissement ;

La figure 5b montre la réponse en fréquence d'un récepteur à plot apériodique compensé à bande passante constante pour trois valeurs de gain, montrant le maintien de l'amortissement.

D'une figure à l'autre, les mêmes éléments sont repérés par les mêmes références.

Le récepteur selon l'invention se fonde sur le principe d'un pont diviseur de courant capacitif au lieu d'être résistif.

Un exemple de plot d'atténuation capacitif associé à une photodiode 1 équipée d'un TIA 2 est montré figure 2. Sur cette figure on s'attache plus particulièrement à indiquer les courants électriques.

La photodiode est un générateur de courant idéal, capacitif du fait de la capacité parasite Cd. En ajoutant une capacité Cp en série entre le TIA 2 et la photodiode 1, en entrée ou en sortie de la capacité de liaison, le courant généré par la photodiode se répartit entre la capacité Cd et la capacité Cp en fonction des valeurs des capacités :

$$I_F = \frac{I_D}{\alpha}$$

via la capacité $C_p$ ;

$$I_{Cd} = \frac{\alpha - 1}{\alpha} I_D$$

via la capacité $C_d$. La valeur de la capacité $C_p = \dfrac{C_d}{\alpha - 1}$ fixe l'atténuation $\alpha = \dfrac{C_d + C_p}{C_p}$ du diviseur capacitif. Le signal est donc atténué sans ajout de bruit supplémentaire.

On a $\alpha > 1$ ; dans la pratique on choisit une atténuation $\alpha$ typiquement comprise entre 2 et 30. La valeur de $C_p$ est typiquement inférieure à 10 pF.

Ce plot d'atténuation 30 constitué de la capacité Cp est éventuellement muni d'un commutateur 31 placé en parallèle de cette capacité Cp pour adapter le gain au niveau reçu.

Analysons plus particulièrement le comportement d'un tel récepteur aux fréquences basses, c'est-à-dire inférieures à 100 kHz :

Comme indiqué en préambule, la photodiode 1 est généralement chargée par une résistance Rd de manière à absorber le courant continu lié à l'éclairement ambiant. Cette résistance Rd modifie l'impédance de la photodiode qui ne peut alors plus être considérée comme purement capacitive.

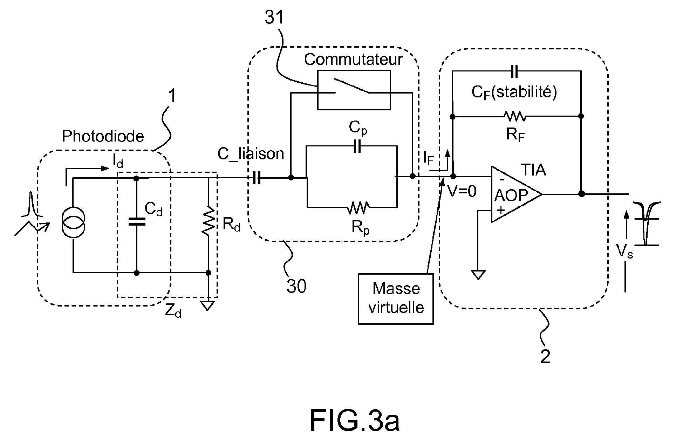

Comme montré figure 3a, on complète alors la capacité Cp avec une résistance Rp en parallèle, qui forme avec cette capacité un réseau électrique parallèle désigné plot d'atténuation 30 apériodique d'impédance Zp proportionnelle à Zd qui est l'impédance du circuit de la diode comportant la résistance $R_d$ et la capacité $C_d$ en parallèle.

En posant $Zp = (\alpha\text{-}1)Zd$, il vient :

$$\begin{cases} I_F = \dfrac{I_D}{\alpha} \\[2mm] R_p = (\alpha - 1)\, R_d \\[2mm] C_p = \dfrac{1}{(\alpha - 1)} C_d \end{cases}$$

$I_F$ étant le courant en sortie du plot d'atténuation 30.

L'atténuation du courant devient alors indépendante de la fréquence, le bruit additif restant très faible puisque la résistance Rp est grande devant Rd du fait du rapport d'atténuation $\alpha$.

Ce plot d'atténuation apériodique 30 est éventuellement muni d'un commutateur 31 disposé en parallèle de Rp et Cp.

A présent, analysons plus particulièrement le comportement d'un tel récepteur aux fréquences hautes c'est-à-dire supérieures à 10 MHz :

Avec le montage précédent de récepteur, l'amplificateur TIA 2 ne voit plus la même impédance lorsque le plot d'atténuation est engagé et sa fonction de transfert en est affectée comme illustré figure 5a pour des courbes de gain en fonction de la fréquence pour trois amortissements $\zeta$ (de 0,9, 0,7 et 0,5). Le montage se comporte comme un système du second ordre.

Le rapport amortissement / pulsation propre :

$$\frac{\hat{\zeta}}{\hat{\omega}_n} = \frac{1}{2}\cdot\left[ R_f.C_f + \frac{1}{2.\pi.GBW}\cdot\left(1 + \frac{R_f}{\alpha.R_d}\right)\right]$$

Lorsque la condition de produit gain x bande suffisant est respectée:

$$R_f . C_f \gg \frac{1}{2\pi\, GBW}\left(1+\frac{R_f}{\alpha\, R_d}\right)$$

le rapport amortissement sur pulsation propre reste constant :

$$\frac{\hat{\zeta}}{\hat{\omega}_n} = \frac{\zeta}{\omega_n} \cong \frac{1}{2} R_f\, C_f$$

Mais :

- La pulsation propre $\hat{\omega}_n$ correspond à celle d'un montage dont la photodiode a une capacité parasite plus faible d'un rapport $\alpha$ :

$$\omega_n = \sqrt{\frac{2\pi\, GBW}{R_f\left(C_d + C_f\right)}} \qquad \Rightarrow \qquad \hat{\omega}_n = \sqrt{\frac{2\pi\, GBW}{R_f\left(\dfrac{C_d}{\alpha} + C_f\right)}}$$

- Le gain statique $Z_T$ est divisé par $\alpha$, ce qui est souhaité :

$$Z_T = -R_f \frac{1}{1+\dfrac{2\zeta}{\omega_n}p+\dfrac{p^2}{\omega_n{}^2}} \qquad \Rightarrow \qquad \hat{Z}_T = \frac{-R_f}{\alpha} \times \frac{1}{1+\dfrac{2\hat{\zeta}}{\hat{\omega}_n}p+\dfrac{p^2}{\hat{\omega}_n{}^2}}$$

Dès lors qu'une atténuation $\alpha$ est réalisée, la pulsation propre $\hat{\omega}_n$ du récepteur augmente mais l'amortissement $\zeta$ augmente puisque le rapport amortissement / pulsation propre reste constant.

Pour conserver la même bande passante avec et sans atténuation, il faut modifier l'amortissement ; on ajoute donc une compensation pour obtenir la même fonction de transfert.

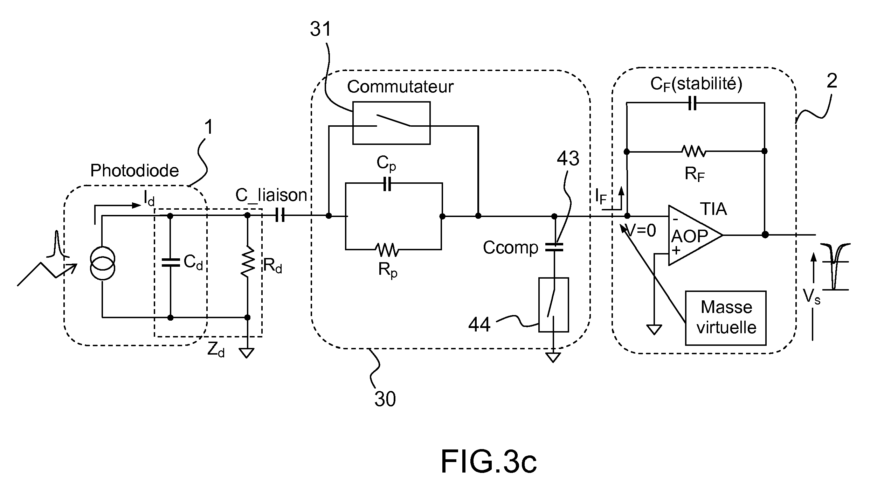

Observant que le rapport amortissement sur pulsation propre est invariant, le maintien simultané de l'amortissement et de la pulsation propre est obtenu en ajoutant une capacité de compensation $C_{comp}$ 43 montrée figure 3c, en parallèle sur l'entrée de l'amplificateur TIA 2 telle que :

$$\omega_n = \hat{\omega}_n \qquad \Leftrightarrow \qquad \sqrt{\frac{2\pi\, GBW}{R_f\left(\dfrac{C_d}{\alpha} + C_{COMP} + C_f\right)}} = \sqrt{\frac{2\pi\, GBW}{R_f\left(C_d + C_f\right)}}$$

Soit :

$$C_{comp} = \frac{\alpha - 1}{\alpha} C_d$$

Le plot d'atténuation apériodique ainsi modifié est alors désigné « plot d'atténuation apériodique compensé ».

Un tel récepteur respecte la même fonction de transfert plot engagé ou non.

En plus du commutateur 31 (premier commutateur), un autre commutateur 44 peut être placé en série avec la capacité de compensation $C_{comp}$, entre elle et la masse. Le plot d'atténuation 30 apériodique compensé fonctionne lorsque cet autre commutateur 44 est fermé et le premier 31 est ouvert et inversement.

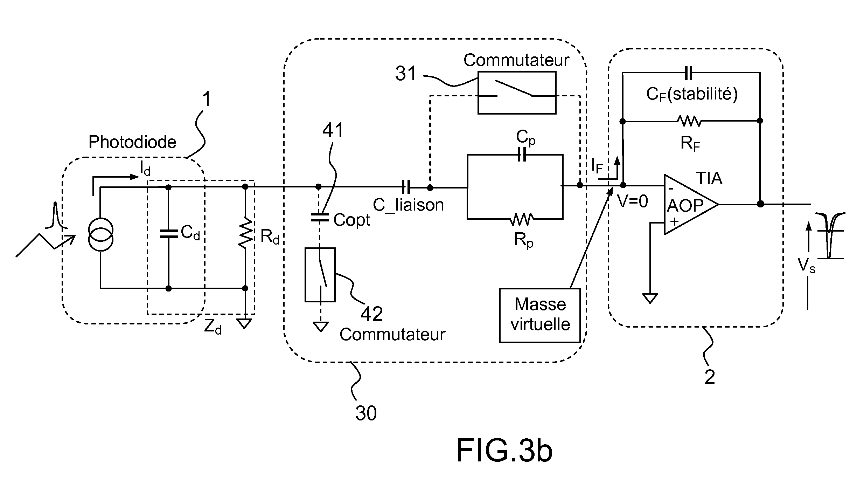

Dans la définition du plot apériodique, la valeur de la capacité $C_p$ est liée à la capacité $C_d$ du détecteur et au rapport d'atténuation. Pour une valeur de Cd comprise entre 12 et 18 pF, on obtient donc par la formule

$$Cp = \frac{1}{(\alpha - 1)} Cd$$

et avec $\alpha$ compris entre 10 et 20, une valeur de Cp très faible comprise entre 0,5 et 2 pF difficilement maitrisable industriellement dans la réalisation d'un montage. La solution proposée fig 3b consiste à augmenter artificiellement la capacité Cd par ajout en parallèle d'une capacité $C_{opt}$ 41, ce qui à atténuation égale permet d'augmenter la valeur de Cp. Cette capacité $C_{opt}$ peut être commutée par un commutateur 42 placé en série vers la masse.

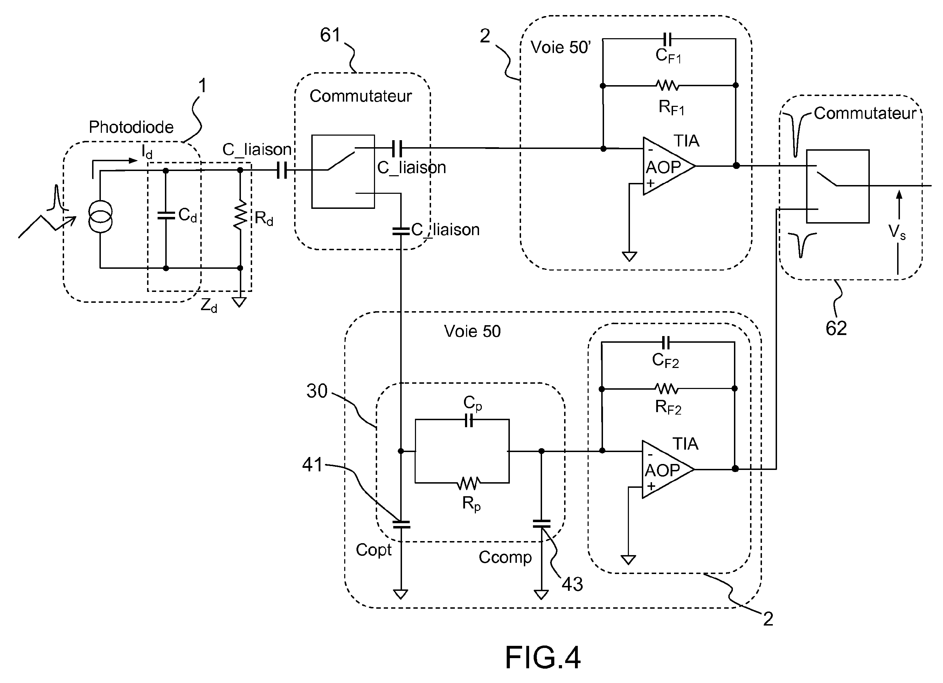

Dans la pratique les commutateurs sont imparfaits et l'implantation peut ajouter des éléments parasites qui peuvent dans certains cas dégrader la fonction de transfert. On désigne par voie de réception avec plot d'atténuation 50, l'ensemble plot d'atténuation 30 et amplificateur transimpédance 2. Le plot d'atténuation peut être apériodique ou non, commutable ou non, compensé ou non etc. Une alternative proposée consiste à utiliser une pluralité de voies de réception, chacune de gain différent, comme sur la figure 4 avec deux valeurs de gain. Dans cet exemple, le récepteur comporte deux voies de réception :

- une voie 50 de réception avec plot, optimisée avec un plot d'atténuation apériodique compensé et

- une voie 50' de réception sans plot (ne comportant qu'un amplificateur transimpédance 2) optimisée à gain maximum.

La sélection de la voie s'effectue typiquement par un commutateur 61 situé en entrée de ces voies et un commutateur 62 situé en sortie de ces voies, synchronisés entre eux pour obtenir un récepteur à différents gains. Le commutateur d'entrée 61 est avantageusement muni d'une capacité de liaison sur chacune de ses sorties vers une voie de réception.

Le récepteur ainsi équipé d'un plot d'atténuation présente les avantages suivants:

• Admissibilité supérieure à celle d'un montage conventionnel ;
• Réponse en fréquence indépendante du gain ;
• Bruit optimisé ;
• Prise en compte des capacités parasites des commutateurs ;
• Pas de compromis à trouver entre sensibilité et tenue en puissance ;
• Réalisation simple.

Ce récepteur est typiquement intégré à un LIDAR. Il peut être utilisé comme élément d'un écartomètre notamment d'un écartomètre semi-actif c'est-à-dire équipé d'un laser de désignation apte à illuminer la cible dont la rétrodiffusion est mesurée par ce récepteur. La cible émet par exemple des impulsions lumineuses de niveau constant, mais lorsque le récepteur est à grande distance, il ne peut mesurer que des impulsions de très bas niveau, alors que lorsqu'il est à courte distance, il peut mesurer des impulsions de fort niveau.

**Revendications**

1.    Récepteur d'un signal lumineux impulsionnel qui comprend :

   - une photodiode (1) apte à générer un courant électrique ($I_D$) en réponse à ce signal lumineux, ayant comme caractéristique une capacité $C_d$,
   - une masse électrique,
   - un amplificateur transimpédance (2) relié en entrée de la photodiode par une capacité de liaison $C_{liaison}$,

   **caractérisé en ce qu'**il comporte un plot d'atténuation (30) situé entre la photodiode et l'amplificateur transimpédance, constitué d'une capacité $C_p$ avec $C_p = C_d/(\alpha-1)$, $\alpha$ étant une atténuation prédéterminée avec $\alpha > 1$.

2.    Récepteur d'un signal lumineux selon la revendication précédente, **caractérisé en ce que** la capacité $C_p$ est située en série avec la capacité de liaison $C_{liaison}$.

3.    Récepteur d'un signal lumineux impulsionnel selon la revendication 1, **caractérisé en ce que** la capacité de liaison est intégrée à la capacité $C_p$.

4.    Récepteur d'un signal lumineux impulsionnel selon l'une des revendications précédentes, **caractérisé en ce qu'**il comporte une résistance $R_d$ de courant de fond de scène située entre la photodiode et la masse électrique, la capacité $C_d$ et ladite résistance $R_d$ ayant une impédance $Z_d$, et **en ce que** le plot d'atténuation est en outre constitué d'une résistance $R_p$ en parallèle avec la capacité $C_p$, formant ainsi un réseau électrique parallèle désigné plot d'atténuation (30) apériodique, d'impédance $Z_p$ avec $Z_p = (\alpha - 1)Z_d$.

5. Récepteur d'un signal lumineux impulsionnel selon l'une des revendications précédentes, **caractérisé en ce que** le plot d'atténuation (30) comporte en outre un commutateur (31) en parallèle de la capacité $C_p$, de manière à obtenir un plot d'atténuation commutable.

6. Récepteur d'un signal lumineux impulsionnel selon l'une des revendications précédentes, **caractérisé en ce que** le plot d'atténuation (30) comporte en outre une capacité $C_{opt}$ (41) en parallèle de $C_d$.

7. Récepteur d'un signal lumineux impulsionnel selon la revendication précédente, **caractérisé en ce que** le plot d'atténuation (30) comporte en outre un commutateur (42) en série de la capacité $C_{opt}$ (41).

8. Récepteur d'un signal lumineux impulsionnel selon l'une des revendications précédentes prise en combinaison avec la revendication 4, **caractérisé en ce que** le plot d'atténuation apériodique (30) est en outre constitué d'une capacité de compensation $C_{comp}$ (43) en parallèle de l'entrée de l'amplificateur transimpédance (2), pour former ainsi un plot d'atténuation apériodique compensé, avec $C_{comp} = C_d(\alpha - 1)/\alpha$.

9. Récepteur d'un signal lumineux impulsionnel selon la revendication précédente prise en combinaison avec la revendication 5, **caractérisé en ce qu'**il comporte en outre un commutateur (44) en série avec la capacité de compensation (43) et relié à la masse, de manière à obtenir une capacité de compensation commutable.

10. Récepteur d'un signal lumineux impulsionnel selon l'une des revendications précédentes, **caractérisé en ce que**, l'ensemble plot d'atténuation (30) et amplificateur transimpédance (2) étant désigné voie de réception à plot d'atténuation (50), il comporte en outre une voie de réception sans plot d'atténuation (50') comportant un autre amplificateur transimpédance, ces voies de réception étant multiplexées au moyen d'un commutateur d'entrée de ces voies (61) et d'un commutateur de sortie de ces voies (62) synchronisés entre eux de manière à obtenir un récepteur à différents gains.

11. Récepteur d'un signal lumineux impulsionnel selon la revendication précédente, **caractérisé en ce qu'**il comporte au moins une autre voie de réception à plot d'atténuation, multiplexée avec lesdites voies de réception (50, 50'), chaque voie de réception à plot d'atténuation présentant une atténuation différente.

12. Récepteur d'un signal lumineux impulsionnel selon l'une des revendications précédentes, **caractérisé en ce que** l'amplificateur transimpédance (2) comporte un amplificateur opérationnel ou un amplificateur à composants discrets.

13. Récepteur d'un signal lumineux impulsionnel selon l'une des revendications précédentes, **caractérisé en ce que** le signal lumineux est apte à générer dans la photodiode des impulsions de courant compris entre 10 nA et 100 mA.

14. Récepteur d'un signal lumineux impulsionnel selon l'une des revendications précédentes, **caractérisé en ce que** $\alpha$ est compris entre 2 et 30.

15. Lidar comportant un récepteur d'un signal lumineux impulsionnel selon l'une des revendications précédentes.

16. Ecartomètre équipé d'un récepteur selon l'une des revendications 1 à 14

17. Ecartomètre selon la revendication précédente, équipé en outre d'un laser de désignation.

**Patentansprüche**

1. Empfänger für ein gepulstes Lichtsignal, der Folgendes umfasst:

  - eine Fotodiode (1), die einen elektrischen Strom ($I_D$) als Reaktion auf das genannte Lichtsignal erzeugen kann, mit einer Kapazität $C_d$ als Charakteristik;
  - eine elektrische Masse;

- einen Transimpedanzverstärker (2), der am Eingang der Fotodiode über eine Bindungskapazität $C_{liaison}$ angeschlossen ist,

**dadurch gekennzeichnet, dass** er eine Dämpfungsstufe (30) umfasst, die sich zwischen der Fotodiode und dem Transimpedanzverstärker befindet, bestehend aus einer Kapazität $C_p$, wobei $C_p = C_d/(\alpha - 1)$ ist, wobei $\alpha$ eine vorbestimmte Dämpfung ist, wobei $\alpha > 1$ ist.

2. Empfänger für ein Lichtsignal nach dem vorherigen Anspruch, **dadurch gekennzeichnet, dass** die Kapazität $C_p$ in Serie mit der Bindungskapazität $C_{liaison}$ geschaltet ist.

3. Empfänger für ein gepulstes Lichtsignal nach Anspruch 1, **dadurch gekennzeichnet, dass** die Bindungskapazität mit der Kapazität $C_p$ integriert ist.

4. Empfänger für ein gepulstes Lichtsignal nach einem der vorherigen Ansprüche, **dadurch gekennzeichnet, dass** er einen Hintergrundstromwiderstand $R_d$ umfasst, der sich zwischen der Fotodiode und der elektrischen Masse befindet, wobei die Kapazität $C_d$ und der Widerstand $R_d$ eine Impedanz $Z_d$ haben, und dadurch, dass die Dämpfungsstufe ferner aus einem Widerstand $R_p$ parallel zur Kapazität $C_p$ besteht, um so ein paralleles Stromnetz, als aperiodische Dämpfungsstufe (30) bezeichnet, mit einer Impedanz $Z_p$ zu bilden, wobei $Z_p = (\alpha - 1)Z_d$ ist.

5. Empfänger für ein gepulstes Lichtsignal nach einem der vorherigen Ansprüche, **dadurch gekennzeichnet, dass** die Dämpfungsstufe (30) ferner einen Schalter (31) parallel zur Kapazität $C_p$ umfasst, um eine schaltbare Dämpfungsstufe zu erhalten.

6. Empfänger für ein gepulstes Lichtsignal nach einem der vorherigen Ansprüche, **dadurch gekennzeichnet, dass** die Dämpfungsstufe (30) ferner eine Kapazität $C_{opt}$ (41) parallel zu $C_d$ umfasst.

7. Empfänger für ein gepulstes Lichtsignal nach dem vorherigen Anspruch, **dadurch gekennzeichnet, dass** die Dämpfungsstufe (30) ferner einen Schalter (42) in Serie mit der Kapazität $C_{opt}$ (41) umfasst.

8. Empfänger für ein gepulstes Lichtsignal nach einem der vorherigen Ansprüche in Kombination mit Anspruch 4, **dadurch gekennzeichnet, dass** die aperiodische Dämpfungsstufe (30) ferner aus einer Kompensationskapazität $C_{comp}$ (43) parallel zum Eingang des Transimpedanzverstärkers (2) besteht, um so eine kompensierte aperiodische Dämpfungsstufe zu bilden, wobei $C_{comp} = C_d(\alpha - 1)/\alpha$.

9. Empfänger für ein gepulstes Lichtsignal nach dem vorherigen Anspruch in Kombination mit Anspruch 5, **dadurch gekennzeichnet, dass** er ferner einen Schalter (44) in Serie mit der Kompensationskapazität (43) und mit Masse verbunden umfasst, um eine schaltbare Kompensationskapazität zu erhalten.

10. Empfänger für ein gepulstes Lichtsignal nach einem der vorherigen Ansprüche, **dadurch gekennzeichnet, dass**, wenn die Baugruppe aus Dämpfungsstufe (30) und Transimpedanzverstärker (2) als Empfangskanal mit Dämpfungsstufe (50) bezeichnet wird, er ferner einen Empfangskanal ohne Dämpfungsstufe (50') umfasst, umfassend einen weiteren Transimpedanzverstärker, wobei die genannten Empfangskanäle mittels eines Eingangsschalters (61) für die genannten Kanäle und eines Ausgangsschalters (62) für die genannten Kanäle miteinander synchronisiert gemultiplext sind, um einen Empfänger mit unterschiedlichen Verstärkungsfaktoren zu erhalten.

11. Empfänger für ein gepulstes Lichtsignal nach dem vorherigen Anspruch, **dadurch gekennzeichnet, dass** er wenigstens einen weiteren Empfangskanal mit Dämpfungsstufe umfasst, gemultiplext mit den Empfangskanälen (50, 50'), wobei jeder Empfangskanal mit Dämpfungsstufe eine andere Dämpfung hat.

12. Empfänger für ein gepulstes Lichtsignal nach einem der vorherigen Ansprüche, **dadurch gekennzeichnet, dass** der Transimpedanzverstärker (2) einen Operationsverstärker oder einen Verstärker mit diskreten Komponenten umfasst.

13. Empfänger für ein gepulstes Lichtsignal nach einem der vorherigen Ansprüche, **dadurch gekennzeichnet, dass** das Lichtsignal in der Fotodiode Strompulse im Bereich von 10 nA bis 100 mA erzeugen kann.

14. Empfänger für ein gepulstes Lichtsignal nach einem der vorherigen Ansprüche, **dadurch gekennzeichnet, dass** $\alpha$ im Bereich von 2 bis 30 liegt.

**15.** LiDAR, das einen Empfänger für ein gepulstes Lichtsignal nach einem der vorherigen Ansprüche umfasst.

**16.** Entfernungsmesser, der mit einem Empfänger nach einem der Ansprüche 1 bis 14 ausgestattet ist.

**17.** Entfernungsmesser nach dem vorherigen Anspruch, der ferner mit einem Lasermarkierer ausgestattet ist.

**Claims**

**1.** A pulsed light signal receiver comprising:

- a photodiode (1) capable of generating an electric current ($I_D$) as a response to said light signal, having a capacitor $C_d$ as a characteristic;
- an electric ground;
- a transimpedance amplifier (2) connected at the input of said photodiode via a link capacitor $C_{liaison}$,

**characterised in that** it comprises an attenuation pad (30) located between said photodiode and said transimpedance amplifier, made up of a capacitor $C_p$, with $C_p = C_d/(\alpha - 1)$, $\alpha$ being a predetermined attenuation, with $\alpha > 1$.

**2.** The light signal receiver according to the preceding claim, **characterised in that** said capacitor $C_p$ is located in series with said link capacitor $C_{liaison}$.

**3.** The pulsed light signal receiver according to claim 1, **characterised in that** said link capacitor is integrated with said capacitor $C_p$.

**4.** The pulsed light signal receiver according to any one of the preceding claims, **characterised in that** it comprises a background current resistor $R_d$ located between said photodiode and said electric ground, said capacitor $C_d$ and said resistor $R_d$ having an impedance $Z_d$, and **in that** said attenuation pad is further made up of a resistor $R_p$ in parallel with said capacitor $C_p$, thus forming a parallel electrical network called aperiodic attenuation pad (30), having an impedance $Z_p$, with $Z_p = (\alpha - 1)Z_d$.

**5.** The pulsed light signal receiver according to any one of the preceding claims, **characterised in that** said attenuation pad (30) further comprises a switch (31) parallel to said capacitor $C_p$, so as to obtain a switchable attenuation pad.

**6.** The pulsed light signal receiver according to any one of the preceding claims, **characterised in that** said attenuation pad (30) further comprises a capacitor $C_{opt}$ (41) parallel to $C_d$.

**7.** The pulsed light signal receiver according to the preceding claim, **characterised in that** said attenuation pad (30) further comprises a switch (42) in series with said capacitor $C_{opt}$ (41).

**8.** The pulsed light signal receiver according to any one of the preceding claims in combination with claim 4, **characterised in that** said aperiodic attenuation pad (30) is further made up of a compensation capacitor $C_{comp}$ (43) parallel to the input of said transimpedance amplifier (2), so as to thus form a compensated aperiodic attenuation pad, with $C_{comp} = c_d(\alpha - 1)/\alpha$.

**9.** The pulsed light signal receiver according to the preceding claim in combination with claim 5, **characterised in that** it further comprises a switch (44) in series with said compensation capacitor (43) and connected to the earth, so as to obtain a switchable compensation capacitor.

**10.** The pulsed light signal receiver according to any one of the preceding claims, **characterised in that**, with the attenuation pad (30) and transimpedance amplifier (2) assembly being designated as reception channel with attenuation pad (50), it further comprises a reception channel without attenuation pad (50') comprising a further transimpedance amplifier, said reception channels being multiplexed by means of an input switch (61) for said channels and an output switch (62) for said channels synchronised together so as to obtain a receiver with different gains.

**11.** The pulsed light signal receiver according to the preceding claim, **characterised in that** it comprises at least one further reception channel with attenuation pad, multiplexed with said reception channels (50, 50'), each reception channel with attenuation pad having a different attenuation.

**12.** The pulsed light signal receiver according to any one of the preceding claims, **characterised in that** said transimpedance amplifier (2) comprises an operational amplifier or an amplifier with discrete components.

**13.** The pulsed light signal receiver according to any one of the preceding claims, **characterised in that** said light signal is capable of generating current pulses in said photodiode ranging from 10 nA to 100 mA.

**14.** The pulsed light signal receiver according to any one of the preceding claims, **characterised in that** $\alpha$ ranges from 2 to 30.

**15.** A LiDAR comprising a pulsed light signal receiver according to any one of the preceding claims.

**16.** A deviometer equipped with a receiver according to any one of claims 1 to 14.

**17.** A deviometer according to the preceding claim, further equipped with a laser designator.

FIG.1a

FIG.1b

$$I_{C_d} = \frac{\alpha-1}{\alpha} I_D \qquad C'_p = \frac{C_d}{\alpha-1} \qquad I_F = \frac{I_d}{\alpha}$$

FIG.2

FIG.3a

FIG.3b

FIG.3c

FIG.4

Gain TIA en configuration Gmax, bande passante constante de 20MHz
GBW=1300MHz, Cd=15pF, Rd=10kOhms

FIG.5a

Récepteur avec plots apériodiques compensés commutés

FIG.5b